# EUROPÄISCHE PATENTSCHRIFT

(11) **EP 1 097 023 B1**
(45) Veröffentlichungstag und Bekanntmachung des Hinweises auf die Patenterteilung: **16.06.2004**
(21) Anmeldenummer: 99942753.7
(22) Anmeldetag: 01.07.1999
(51) Int. Cl.: B23K 26/08

(54) **VORRICHTUNG ZUM LASERBEARBEITEN VON WERKSTÜCKEN**
DEVICE FOR THE LASER PROCESSING OF WORKPIECES
DISPOSITIF POUR L'USINAGE AU LASER DE PIECES

(30) Priorität: 13.07.1998 DE 19831343
(43) Veröffentlichungstag der Anmeldung: 09.05.2001
(73) Patentinhaber: Siemens Production and Logistics Systems AG, 90475 Nürnberg (DE)
(72) Erfinder: SCHOLL, Bernd-Friedrich, D-70771 Echterdingen (DE); MÜLLER, Lothar, D-69124 Heidelberg (DE); JUNG, Werner, D-68753 Waghäusel (DE); DIETRICH, Stefan, D-76185 Karlsruhe (DE)
(74) Vertreter: Berg, Peter, Dipl.-Ing.
(86) Internationale Anmeldenummer: PCT/DE1999/001935
(87) Internationale Veröffentlichungsnummer: WO 2000/003831

(56) Entgegenhaltungen:
- US-A- 5 578 229
- PATENT ABSTRACTS OF JAPAN vol. 015, no. 362 (M-1157), 12. September 1991 (1991-09-12) & JP 03 142090 A (CANON INC), 17. Juni 1991 (1991-06-17)
- PATENT ABSTRACTS OF JAPAN vol. 010, no. 018 (M-448), 24. Januar 1986 (1986-01-24) & JP 60 177982 A (SUMITOMO DENKI KOGYO KK), 11. September 1985 (1985-09-11)

## Beschreibung

Die Erfindung bezieht sich auf eine Vorrichtung zum Laserbearbeiten von Werkstücken mit einander diametral gegenüberliegenden Bearbeitungsflächen.

Bei der Herstellung von feinen Oberflächenstrukturen z.B. bei Leiterplatten ist es bekannt, Leit- oder Deckschichten mittels eines Laserstrahls mit hoher Genauigkeit zu strukturieren. Bei doppelseitig kaschierten Leiterplatten muß die Leiterplatte gewendet und zum zweiten Mal in den Arbeitsbereich der Lasereinheit gebracht werden.

Durch die US 5 678 229 A ist eine Laserschneideinrichtung für Platten bekannt geworden, bei das Werkstück zwischen zwei gegeneinander gerichteten Lasereinheiten angeordnet wird, deren optische Achsen genau aufeinander ausgerichtet sind, so daß die verschiebbar geführten Platten einen sauberen Trennschnitt erhalten können.

Durch die JP 03142090 A ist ferner einer Laserbohreinrichtung für Leiterplatten bekannt geworden, bei der die Löcher von zwei Lasereinrichtungen erzeugt werden, deren über feste Umlenkspiegel geführte Laserstrahlen in ihrer optischen Achse ebenfalls genau aufeinander ausgerichtet sind. Zum Bohren anderer Löcher muß die Leiterplatte entsprechend verschoben werden

In ähnlicher Weise werden nach der JP 60177982 ist eine ähnliche Einrichtung zum gleichzeitigen und beiderseitigen Markieren von Platten bekannt geworden, bei der jedoch die Laserstrahlen über einen Strahlenteiler und mehrfache feste Umlenkspiegel von beiden Seiten aufeinander justiert sind.

Der Erfindung liegt die Aufgabe zugrunde, die Bearbeitungsgenauigkeit zu erhöhen und die Bearbeitungsdauer zu verkürzen.

Diese Aufgabe wird durch die Erfindung gemäß Anspruch 1 gelöst. Da die beiden Lasereinheiten unabhängig voneinander steuerbar sind, können auf beiden Seiten unterschiedliche Muster erzeugt werden, ohne die Leiterplatte verfahren zu müssen, wodurch sich die Bearbeitungsdauer halbiert. Außerdem entfällt der Umwend-, Wechsel- und Justieraufwand zur Bearbeitung der zweiten Leiterplattenseite. Die Position des Werkstücks muß nur einmal erfaßt werden. Die beiden Lasereinheiten können derart vorjustiert werden, daß die Bearbeitungsbilder zu beiden Seiten der Leiterplatte ohne Differenzen zur Deckung gelangen.

Durch die Verwendung steuerbaren Ablenkeinheiten können ohne die Verwendung von Masken unterschiedliche Strukturen auf beiden Seiten der Leiterplatte erzeugt werden.

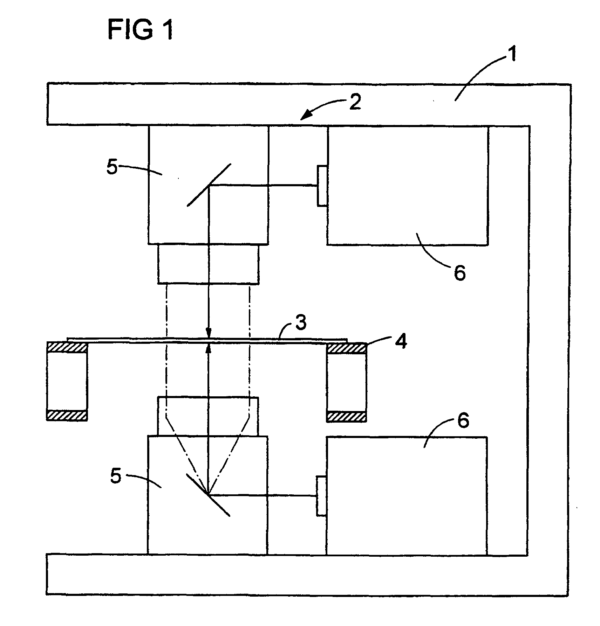

Im folgenden wird die Erfindung anhand eines in der Zeichnung dargestellten Ausführungsbeispieles näher erläutert. Die dargestellte Figur 1 zeigt in einer schematisierten Seitenansicht einen Tragrahmen 1 mit zwei Lasereinheiten 2, einem als Leiterplatte ausgebildeten Werkstück 3 und einem als lineare Transporteinrichtung ausgebildeten beweglichen Träger 4, dessen Transportrichtung senkrecht zur Bildebene verläuft.

Die Lasereinheit 2 besteht aus einem Laserstrahlerzeuger 5 und einer Umlenkeinrichtung 6, durch die der Laserstrahl in zwei Koordinatenrichtungen derart auslenkbar ist, daß er jeweils senkrecht zur Werkstückoberfläche gerichtet ist. Die beiden Lasereinheiten 2 sind oberhalb und unterhalb des Werkstücks 3 derart angeordnet, daß ihre abgehenden Strahlen einander entgegengesetzt gerichtet sind. Beide Oberflächen des Werkstücks 3 erfassen. Diese können nun gleichzeitig bearbeitet werden und danach durch den beweglichen Träger 4 soweit verfahren werden, daß ein anderer Bearbeitungsbereich der Leiterplatte in den Strahlungsbereich der Lasereinheit 2 gelangt oder bis das Werkstück 3 den Laserbereich verlassen hat.

Das Werkstück 3 kann zum Beispiel als normale Leiterplatte ausgebildet sein, bei der einzelne Bereiche besonders fein strukturiert werden müssen. Es ist aber auch möglich, anstelle der Leiterplatte beispielsweise eine Leiterfolie zu verwenden und diese zwischen den beiden Umlenkeinrichtungen 6 schrittweise hindurchzuziehen. Die Werkstücke 3 können auch z.B. als relativ kleine Chipträger ausgebildet sein und in einer Vielzahl von Aufnahmen eines Werkstückträgers fixiert sein, der mit entsprechenden Freimachungen zum Durchtritt der Laserstrahlen versehen ist. In diesem Falle erfaßt der Träger 4 der Werkstückträger und führt ihn so, daß die einzelnen Werkstücke sukzessive in den Laserstrahlbereich gelangen.

## Patentansprüche

1. Vorrichtung zum Laserbearbeiten von beidseitig kaschierten plattenartigen Leiterbahnträgern (3) mit einander diametral gegenüberliegenden Bearbeitungsflächen,
wobei die Vorrichtung zwei gegeneinander gerichtete Lasereinheiten (2) aufweist,
wobei die Werkstücke an einem beweglichen Träger (4) fixierbar sind und zwischen den beiden Lasereinheiten (2) plazierbar sind und
wobei die beiden Lasereinheiten (2) gleichzeitig betreibbar sind,
**dadurch gekennzeichnet,** daβ die beiden Lasereinheiten derart unabhängig voneinander steuerbar sind, daβ auf beiden Seiten des Leiterbahnträgers unterschiedliche Muster erzeigt werden kann, ohne den Leiterbahnträger (3) zu verfahren , und
daß die beiden Lasereinheiten mit einer internen Strahlablenkung (5) versehen sind, die den jeweils zu bearbeitenden Bereich des Werkstücks (3) überdeckt.

## Claims

1. Device for the laser processing of board-type conductor supports (3) coated on both sides with diametrically opposed processing areas,
whereby the device has two laser units (2) directed towards each other,
whereby the workpieces can be fixed on a movable support (4) and can be positioned between the two laser units (2) and
whereby the two laser units (2) can be operated at the same time, **characterized in that**
the two laser units can be controlled independently of each other so that different patterns can be generated on both sides of the conductor support, without moving the conductor support (3) and
the two laser units are provided with an internal beam deflector (5), which covers the area of the workpiece (3) to be processed in each instance.

## Revendications

1. Dispositif pour l'usinage au laser de supports de pistes conductrices (3) tels que des plaquettes masquées des deux côtés avec des faces à usiner diamétralement opposées,
le dispositif présentant deux unités laser (2) dirigées l'une contre l'autre,
les pièces à usiner pouvant être fixées sur un support mobile (4) et placées entre les deux unités laser (2) et
les deux unités laser (2) pouvant être exploitées simultanément,
**caractérisé en ce**
**que** les deux unités laser sont commandables indépendamment l'une de l'autre de manière telle qu'il est possible de produire des dessins différents de part et d'autre du support de pistes conductrices sans déplacer le support de pistes conductrices (3) et
**que** les deux unités laser sont pourvues d'une déviation interne de rayons (5) qui recouvre la partie à usiner respective de la pièce à usiner (3).
